# EUROPÄISCHE PATENTSCHRIFT

(11) **EP 0 673 188 B1**
(45) Veröffentlichungstag und Bekanntmachung des Hinweises auf die Patenterteilung: **01.07.1998**
(21) Anmeldenummer: 95103515.3
(22) Anmeldetag: 10.03.1995
(51) Int. Cl.: H05K 3/34, B23K 35/02

(54) **Gurtband zum Bereitstellen von Lotdepots zum Auflöten von Bauelementen auf eine Leiterplatte**
Belt for providing solder depots for soldering components on a printed circuit board
Sangle pour fournir des dépôts de soudure pour le soudage de composants sur une plaquette de circuit imprimé

(30) Priorität: 15.03.1994 DE 4408771
(43) Veröffentlichungstag der Anmeldung: 20.09.1995
(73) Patentinhaber: Mayer, Heinrich, 86179 Augsburg (DE); Merkenschlager, Hans-Hermann, 86179 Augsburg (DE)
(72) Erfinder: Mayer, Heinrich, Dipl.-Ing.(FH), D-86179 Augsburg (DE); Koch, Volker-Ekkehart, Dr.rer.nat., D-86630 Schwabmünchen (DE); Merkenschlager, Hans-Hermann, Dipl.-Ing., D-86179 Augsburg (DE)

(56) Entgegenhaltungen:
- FR-A- 2 172 155
- GB-A- 2 142 568
- US-A- 5 118 027
- PATENT ABSTRACTS OF JAPAN vol. 13, no. 376 (M-862) 21. August 1989 & JP-A-01 130 897 (NEC CORP.) 23. Mai 1989
- PATENT ABSTRACTS OF JAPAN vol. 7, no. 115 (E-176) 19. Mai 1983 & JP-A-58 035 935 (FUJITSU KK) 2. März 1983
- IBM TECHNICAL DISCLOSURE BULLETIN., Bd.17, Nr.2, Juli 1974, NEW YORK US Seite 627 J.R. GETTEN ET AL. 'Interface array connector system'

## Beschreibung

Die Erfindung betrifft ein Gurtband zum Bereitstellen von Lotdepots zum Auflöten von Bauelementen auf eine Leiterplatte gemäß dem Oberbegriff des Anspruchs 1.

Zum Auflöten von Bauelementen auf eine Leiterplatte, wobei die Bauelemente ein flächiges Anschlußfeld aufweisen, sogenannte "Ball-Grid-Arrays", ist bekannt, mittels eines folienartigen lötbeständigen Trägermaterials, im folgenden auch mit Gurtband bezeichnet, Lotdepots bereitzustellen, die in Durchbrüchen des Trägermaterials angeordnet sind. Die Anordnung in dem Trägermaterial entspricht der Verteilung der Anschlüsse des aufzulötenden Bauelements. Bei den Lotdepots handelt es sich beispielsweise um kugelförmige Lotteilchen, die in den Durchbrüchen festgeklemmt sind und das Trägermaterial sowohl auf der einen als auch auf der anderen Seite überragen.

Beim Auflöten eines Bauelementes auf eine Leiterplatte wird das Trägermaterial mit den Lotdepots zwischen dem aufzulötenden Bauelement und der Leiterplatte angeordnet. Die Lotdepots werden dann gleichzeitig geschmolzen, wodurch das Bauelement in einem Durchgang angelötet und elektrisch leitend mit der Leiterplatte verbunden wird. Aus der Schrift DE-OS 1 515 885 ist beispielsweise ein solches Gurtband bekannt. Ebenso ist ein solches Gurtband aus Patent Abstract of Japan, JP 58-35 935 (A), Application No. 56-135 172 bekannt.

Nachteilig bei der Verwendung der bekannten Gurtbänder ist, daß unter Umständen bei einzelnen Anschlußstellen innerhalb des Anschlußfeldes eines aufzulötenden Bauelementes keine elektrisch leitende Verbindung zwischen dem aufzulötenden Bauelement und der Leiterplatte hergestellt wird. Ein möglicher Grund dafür ist, daß die Ebenen der Anschlüsse der Bauelemente und der Leiterplatte nicht hundertprozentig plan sind, so daß Höhenunterschiede zwischen den einzelnen Anschlußstellen innerhalb eines Anschlußfeldes bestehen, so daß die an sich gleich großen Lotdepots nicht überall vor dem Lötvorgang einen mechanischen Kontakt zwischen dem aufzulötenden Bauelement und der Leiterplatte herstellen. Eine mögliche Ursache können aber auch kleine Unterschiede in den Dicken der verwendeten Lotteilchen sein.

Daneben ist aus JP-A-1 130 897 ein Gurtband zum Bereitstellen von Lotdepots zum Auflöten von Bauelementen auf eine Leiterplatte bekannt. Es besteht aus einem lötbeständigen Trägermaterial, das Durchbrüche in einer Rasteranordnung aufweist, das den Anschlußstellen eines auf einer Leiterplatte aufzulötenden Bauelements mit flächig verteilten Anschlußstellen entspricht. In den Durchbrüchen sind Lotkörner angeordnet, die das Trägermaterial nach beiden Seiten hin überragen. Die Lotkörner, bei denen es sich anfänglich um kleine Kügelchen handelt, sind in die Durchbrüche des Trägermaterials nahezu vollständig hineingepreßt. Geringfügige Überstände sind auf beiden Seiten des Trägermaterials vorhanden, wobei der Materialverlauf jeweils über die Abmessungen der Durchbrüche hinausreicht. Insgesamt weisen die Lotkörner gegenüber ihrer Ausgangsform eine vollständig andere, nämlich weitgehend niedergedrückte Form auf.

Aufgabe der Erfindung ist daher, ein Gurtband der eingangs genannten Art anzugeben, das eine sichere Verlötung aller Anschlußstellen zwischen einem aufzulötenden Bauelement und einer Leiterplatte ermöglicht.

Diese Aufgabe wird durch ein Gurtband gelöst, das die kennzeichnenden Merkmale des Anspruchs 1 aufweist.

Durch das Flachpressen der Lotkörner an den Kappen der das Gurtband überragenden Teilen werden die Lotkörner in den Durchbrüchen des Trägermaterials zum einen festgeklemmt. Flachgepreßte Lotkörner haben aber zum anderen auch das Bestreben, beim Schmelzen während des Auflötens eines Bauelementes auf die Leiterplatte wegen der erzeugten Oberflächenspannung wieder zu einer Kugelform aufzuschmelzen. Hierdurch ist eine Hubbewegung bedingt, die unterschiedliche Abstände zwischen zwei zu verbindenden Teilen ausgleichen kann. Damit wird bei allen Lötstellen innerhalb eines Anschlußfeldes zwischen einem aufzulötenden Bauelenent und einer Leiterplatte eine qualitätsmaßig einwandfreie Lötverbindung erzeugt.

Verbleibt das die Lotkörner tragende Trägermaterial zwischen dem Bauelement und der Leiterplatte, kann es als Abstandshalter verwendet werden. Außerdem dient es als mechanische Sperre gegen Lotbrücken.

Zwar ist aus dem Patent US-A-4 209 893 ein folienartiges lötbeständiges Trägermaterial bekannt, das Durchbrüche aufweist, in denen flachgepreßte Lotdepots angeordnet sind. Diese Lotdepots sind aber einerseits so stark flachgepreßt, daß sie die Dicke des Trägermaterials aufweisen und nicht mehr zu einer Kugelform aufschmelzen. Andererseits werden die Lotdepots gelocht, weil später Stifte hindurchgreifen sollen. Die Lotdepots dienen daher insgesamt einem anderen Zweck und können nicht die geforderte Aufgabe erfüllen.

Vorteilhafte Ausgestaltungen der Erfindung sind Gegenstand von Unteransprüchen.

Werden zwei Schichten jeweils eines folienartigen lötbeständigen Trägermaterials für die Bildung eines Gurtbandes verwendet, die entsprechende ausgeformte und angeordnete Durchbrüche aufweisen derart, daß beide Schichten zusammen für die Lotkörner Durchbrüche mit konkav-V-förmigen Wänden aufweisen, kann ein Rasteffekt bei der Anordnung der Lotkörner in den Durchbrüchen des Trägermaterials genutzt werden. Durch den Rasteffekt werden dann die Lotkörner schon bei deren Anordnung in den Durchbrüchen der zusammengefaßten Trägermaterialien gehalten.

Nachfolgend wird die Erfindung anhand einer Zeichnung näher erläutert. Darin zeigen
Figur 1 einen Ausschnitt eines Gurtbandes in einer Vorstufe der Erfindung in Draufsicht,
Figur 2 eine Schnittdarstellung des Gurtbandes nach Figur 1 entlang der Linie II-II,
Figur 3 ein Ausführungsbeispiel eines Gurtbandes gemaß der Erfindung in einer Schnittdarstellung entlang der angegebenen Linie II-II in Figur 1, und
Figur 4 ein weiteres Ausführungsbeispiel eines Gurtbandes gemäß der Erfindung in einer Schnittdarstellung entlang der Linie II-II in Figur 1.

Für die nachfolgende Beschreibung der Figuren gilt, daß gleiche Bezugszeichen gleiche Bauteile angeben.

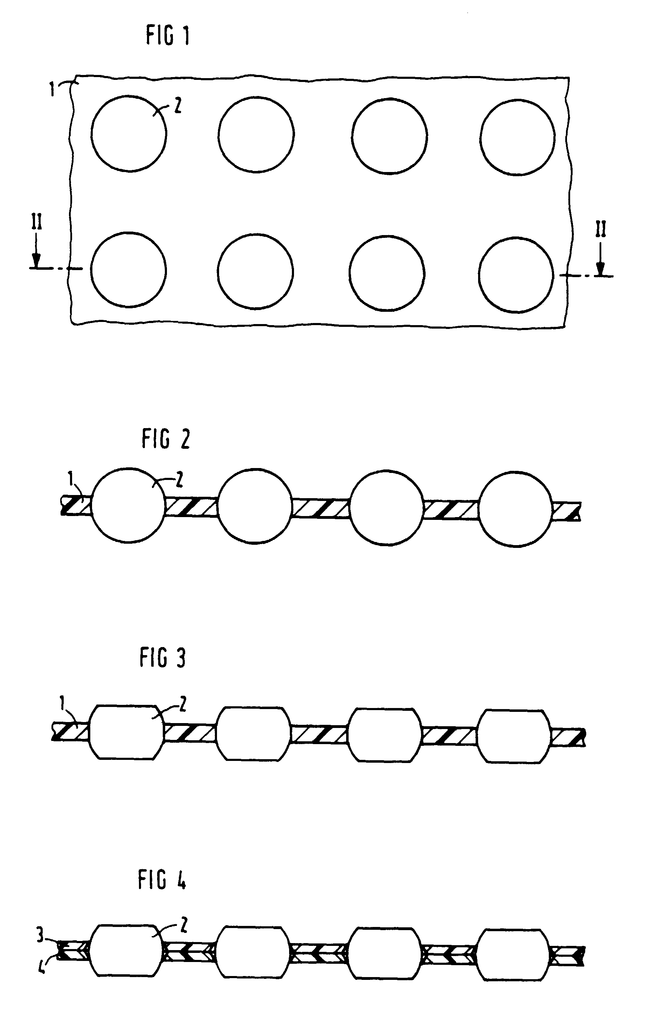

In der Figur 1 ist ein Gurtband mit runden Durchbrüchen gezeigt, in denen Lotkörner 2 herausfallsicher gehalten sind. Die Lotkörner 2 sind aus einem Granulat von Lotkugeln gebildet. Die Lotkörner 2 könnten auch aus einem Granulat von Lotelementen mit einer anderen Form gebildet sein.

Das Gurtband selbst ist aus einem gegenüber den Lotkörnern 2 flacheren folienartigen lötbeständigen Trägermaterial 1 gebildet. Die Durchbrüche und damit auch die Lotkörner 2 sind in dem Gurtband in einem Raster angeordnet, das einer Anordnung gemäß der Anordnung der zu verbindenden Stellen zwischen einem auf eine Leiterplatte aufzulötenden Bauelement und der Leiterplatte entspricht.

Gemäß der Figur 2 sind die Lotkörner 2 innerhalb der Durchbrüche des Trägermaterials 1 in der Weise angeordnet, daß die Lotkörner 2 zur Hälfte durch die Durchbrüche des Trägermaterials 1 hindurchgreifen. Dieser Grad der Durchdringung der Durchbrüche kann als maximaler Durchdringungsgrad angesehen werden, da sich dann die Verhältnisse umdrehen. Ein geringerer Durchdringungsgrad als der in der Figur 2 gezeigte für die Lotkörner 2 kann gewählt sein.

Bei dem in der Figur 2 gewählten Durchdringungsgrad für die Lotkörner 2 durch die Durchbrüche des Trägermaterials 1 in Verbindung mit Lotkugeln als Lotkörner 2 ist für die Dimensionierung der Öffnungsweiten der Durchbrüche ein wirksamer Umfang der Lotkörner 2 maßgebend, der durch den maximalen Umfang der Lotkugeln vorgegeben ist. Bei einem entsprechend kleineren Durchdringungsgrad stellt ein entsprechend kleinerer Umfang der Lotkörner den wirksamen Umfang der Lotkörner 2 dar. In diesem Fall ist die Dimensionierung der Öffungsweiten der Durchbrüche entsprechend kleiner zu wählen.

Diese Abhängigkeit bei der Dimensionierung der Öffnungsweite der Durchbrüche des Trägermaterials 1 ist prinzipiell bei jeder Form der verwendeten Lotkörner 2 zu berücksichtigen, wobei gegebenenfalls noch formspezifische Parameter zu berücksichtigen sind. Entsprechendes gilt, wenn anstelle runder Durchbrüche eckige Durchbrüche verwendet werden.

Für die weitere Beschreibung wird davon ausgegangen, daß die Durchbrüche rund und für die Lotkörner 2 Lotkugeln verwendet sind.

Der Durchmesser der Durchbrüche kann gleich oder geringfügig größer als der wirksame Umfang, im vorliegenden Fall der Durchmesser der Lotkörner 2, gewählt sein. Eine Befestigung der Lotkörner 2 in den Durchbrüchen erfolgt mit dem Flachpressen der Lotkörner 2, wie es in der Figur 3 dargestellt ist. Durch das Flachpressen werden die Lotkörner 2 seitlich etwas auseinandergedrückt, so daß es zu einem Einpressen der Lotkörner 2 in den jeweiligen Durchbrüchen kommt.

Der Durchmesser der Durchbrüche kann auch geringfügig kleiner als der wirksame Umfang, im vorliegenden Fall der Durchmesser der Lotkörner 2, gewählt sein. In diesem Fall erfahren die Lotkörner 2 bereits beim Anordnen in den Durchbrüchen einen Klemmsitz und werden herausfallsicher gehalten.

Die Lotkörner 2 können mit einem gegenüber ihrem Schmelzpunkt niedriger schmelzendem Lot beschichtet sein. Dies hat den Vorteil, daß sie beispielsweise an Bauteilanschlüssen eines aufzulötenden Bauelements angelötet werden können, ohne daß hierbei die Lotkörner 2 selbst schon schmelzen. Diese sollen erst beim Auflöten des Bauteils auf die Leiterplatte schmelzen.

Eine Beschichtung mit einem gegenüber dem Schmelzpunkt der Lotkörner 2 niedriger schmelzendem Lot kann in Ergänzung oder als Alternative zur entsprechenden Beschichtung der Lotkörner 2 beispielsweise auf den Bauteilanschlüssen eines aufzulötenden Bauelementes oder auf den, den Bauteilanschlüssen des aufzulötenden Bauelements zugeordneten Anschlußstellen der Leiterplatte erfolgen.

Das in den Figuren 1 bis 3 angesprochene, aus dem Trägermaterial 1 bestehende Gurtband kann, wie in der Figur 4 dargestellt, aus zwei unabhängigen Schichten 3, 4 von jeweils einem Trägermaterial 1 gebildet sein, die jeweils in einem Raster, das einer Anordnung gemäß der Anordnung der zu verbindenden Stellen zwischen einem zu verbindenden Bauelement und der Leiterplatte entspricht, gleiche Durchbrüche mit angeschrägten Wänden aufweisen. Durch die angeschrägten Wände der Durchbrüche weisen die Durchbrüche Öffnungsränder mit einer kleineren und einer größeren Öffnungsweite auf. Die einzelnen Öffnungsweiten, für die im übrigen in Bezug auf Anpassung an andere Lotkörner- und Durchbruchformen Entsprechendes wie oben gesagt gilt, sind in der Weise gewählt, daß die Öffnungsränder mit der kleineren Öffnungsweite eine geringfügig kleinere und die Öffnungsränder mit der größeren Öffnungsweite eine geringfügig größere Öffnungsweite als der Durchmesser der verwendeten Lotkörner 2 aufweist. Die Schichten 3, 4 sind aufeinandergelegt angeordnet derart, daß die Durchbrüche der einzelnen Schichten 3, 4 fluchten und zusammen für die Lotkörner 2 Durchbrüche mit konkav-V-förmigen Wänden bilden.

## Patentansprüche

1. Gurtband bestehend aus einem folienartigen lötbeständigen Trägermaterial, das Durchbrüche mit das Trägermaterial nach beiden Seiten hin überragenden Lotkörnern in einer Rasteranordnung aufweist, die der Rasteranordnung der Anschlußstellen eines auf einer Leiterplatte aufzulötenden Bauelementes mit flächig verteilten Anschlußstellen entspricht, **dadurch gekennzeichnet**, daß die Lotkörner (2) an den Kappen der das Trägermaterial (1) überragenden Teilen im wesentlichen unter Beibehaltung ihrer Ausgangsform derart flachgepreßt sind, daß die Lotkörner (2) während des Auflötens zu einer Kugelform aufschmelzen.

2. Gurtband nach Anspruch 1, **dadurch gekennzeichnet,** daß die Lotkörner (2) mit einem niedriger schmelzenden Lot als der Schmelzpunkt der Lotkörner (2) beschichtet sind.

3. Gurtband nach Anspruch 1 oder 2, **dadurch ge-kennzeichnet,** daß das Gurtband aus zwei unabhängigen Schichten (3, 4) von jeweils einem folienartigen lötbeständigen Trägermaterial (1) gebildet ist, die jeweils in einer Anordnung entsprechend der Anordnung der zu verbindenden Stellen zwischen einem zu verbindenden Bauelement und der Leiterplatte gleiche Durchbrüche mit angeschrägten Wänden aufweisen derart, daß die sich durch die angeschrägten Wände ergebenden Öffnungsränder der Durchbrüche mit der kleineren Öffnungsweite eine geringfügig kleinere und die Öffnungsränder mit der größeren Öffnungsweite eine geringfügig größere Öffnungsweite als ein wirksamer Umfang der Lotkörner (2) abhängig von einem vorgewählten Durchdringungsgrad der Lotkörner (2) durch die Durchbrüche des Trägermaterials (1) aufweisen, und daß die Schichten (3, 4) mit zueinander fluchtenden Öffnungen in der Weise aufeinandergelegt angeordnet sind, daß beide Schichten (3, 4) zusammen für die Lotkörner (2) Öffnungen mit konkav-V-förmigen Wänden aufweisen.

4. Gurtband nach einem der vorherigen Ansprüche, **dadurch gekennzeichnet,** daß die Lotkörner (2) als Lotkugeln ausgebildet sind.

5. Gurtband nach einem der Ansprüche 1 bis 4, **dadurch gekennzeichnet,** daß die Durchbrüche in einem jeweiligen Trägermaterial (1) als Rundlöcher ausgebildet sind.

6. Gurtband nach einem der Ansprüche 1 bis 4, **dadurch gekennzeichnet,** daß die Durchbrüche in einem jeweiligen Trägermaterial (1) mehreckig ausgebildet sind.

## Claims

1. Belt composed of a foillike solder resistant material, with openings filled with solder grains which exeed the material on both sides and are arranged in a grid array corresponding to the grid array of the pads of a component with flat distributed pads which is to be soldered on a printed circuit board comprising solder grains of which the material exceeding parts are compressed in such a way that the solder grains regain a spheric form during melting in the soldering process.

2. Belt according to claim 1, characterised in that solder grains (2) are coatet with a lower melting solder than the melting point of the solder grains (2).

3. Belt according to claim 1 or 2, characterised in that the belt is formed by two independent foillike solder resistant layers (3,4) of material (1) with identical openings arranged corresponding to the arrangement of the connecting points between a component to be connected to a printed circuit board and the printed circuit board with walls slanted in such a way that the resulting opening edge of the openings with the smaller opening has a slightly smaller width and the opening edge with the larger openings has a slightly larger opening width than the effective perimeter of the solder grains (2) depending on a preselected penetration grade of the solder grains (2) through the openings of the material (1) and that the layers (3,4) with aligning openings are superposed in such a way, that the two layers (3,4) form concave-v-formed walls for the solder grains (2).

4. Belt according to one of the precedent claims, in which the solder grains (2) are spheric.

5. Belt according to one of the claims 1 to 4, in which the openings in the material (1) are circular.

6. Belt according to one of the claims 1 to 4, in which the openings in the material (1) are polygonal.

## Revendications

1. Bande composée d'un matériel de support résistant au brasage qui comporte des perforations contenant des plombs de brasage dépassant des deux côtés qui sont arrangés dans une trame correspondante à la trame des connexions d'un composant de construction à connexion distribué en plan d'un composant à braser sur une carte de circuits imprimés caractérisée en ce que, les calottes des plombs de brasage dépassent le matériel de support tout essentiellement gardant leur forme initiale en sorte que les plombs de brasage(2) fondent en forme sphérique pendant le brasage.

2. Bande selon la revendication 1 caractérisée en ce que, les plombs de brasage(2) sont couverts d'une couche d'alliage ayant un point de fusion inférieur au point de fusion de plombs de brasage.

3. Bande selon les revendications 1 ou 2 caractérisée en ce que, la bande est composée de deux couches (2,4) indépendantes dont chacune consiste en matériel résistant au brasage et dont chacune comporte des perforations identiques aux parois obliqués groupés dans un arrangement correspondant à l'arrangement des connexions d'un composant et d'une carte des circuits imprimés en sorte que, grâce à l'obliquité de parois, l'ouverture du côté des perforations à ouverture inférieur soit légèrement inférieur et l'ouverture du cotés des perforations à ouverture supérieur soit légèrement supérieur au périmètre effectif des plombs de brasage(2) en dépendance du degré de pénétration présélectionné des plombs de brasage(2) dans les perforations du matériel (1) de la bande et en sorte que, les couches(3,4) sont superposées avec des perforations alignées en sorte que, les deux couches(3,4) comportent ensemble des ouvertures avec parois concaves en forme de V pour les plombs (2)

4. Bande selon d'une des revendications précédentes caractérisée en ce que, les plombs de brasage(2) sont sphériques.

5. Bande selon l'une des revendications(1-4) caractérisée en ce que, les perforations de la bande(1) sont circulaires.

6. Bande selon l'une des revendications(1-4) caractérisée en sorte que, les perforations dans le matériel de la bande sont polygonales.
